# EUROPÄISCHE PATENTANMELDUNG

(11) **EP 0 921 538 A2**
(43) Veröffentlichungstag der Anmeldung: **09.06.1999**
(21) Anmeldenummer: 98124766.1
(22) Anmeldetag: 15.12.1995
(51) Int. Cl.: H01F 27/02, H01F 17/02

(54) **Elektrisches Bauteil, insbesondere Spule, vorzugsweise für SMD-Montage-Technik**

(30) Priorität: 19.12.1994 DE 9420283 U
(62) Teilanmeldung aus: 95941585.2
(71) Anmelder: Hagn, Erwin, 85368 Moosburg (DE)
(72) Erfinder: Hagn, Erwin, 85368 Moosburg (DE)
(74) Vertreter: R.A. KUHNEN & P.A. WACKER

(57) **Zusammenfassung**

Es wird ein elektrisches Bauteil offenbart, das, insbesondere als Spule ausgebildet ist und vorzugsweise für SMD-Montagetechnik vorgesehen ist. Zur Erleichterung der Montage ist auf einer Bauteil-Seite, insbesondere der Bauteil-Oberseite, ein Massepunkt aufgebracht, der eine vorzugsweise plane Oberfläche besitzt und derart angeordnet ist, daß er gegenüber zumindest einem Seitenrand des Bauteils beabstandet ist.

## Beschreibung

Die Erfindung betrifft ein vorzugsweise elektrisches Bauteil, das vorzugsweise für SMD-Montagetechnik (SMD = Surface Mounted Devices) ausgelegt ist, und ist insbesondere auf eine elektrische Spule gerichtet.

Aufgrund der weitgehenden Miniaturisierung von Schaltungen und Schaltplatinen sind üblicherweise auch die Abmessungen der einzelnen elektrischen Bauteile erheblich verringert, was deren manuelle oder automatische Handhabbarkeit beeinträchtigt.

Es hat sich als vorteilhaft erwiesen, zur Handhabung von elektrischen Bauteilen mittels Bestückungsautomaten eine plane Oberfläche bereitzustellen, über die das Bauteil mittels der Ansaugpipette angesaugt werden kann. Es ist bereits bekannt, elektrische Bauteile, die nicht von Haus aus über eine solche plane Oberseite verfügen, vollständig einzukapseln oder mit einer oberseitigen Platte zu versehen. Hierbei erstreckt sich allerdings die Einkapselung oder die oberseitige Platte über die Seitenränder der Bauteile, beispielsweise der Spulen. Dies vergrößert deren seitliche Abmessungen, was in manchen Fällen unerwünscht sein kann. Insbesondere bei mechanischer Abtastung, bei der der Abtast- oder Greifkopf die Seitenränder zur exakten Positionierung des Bauteils in der Sollposition abtastet, kann der Abtastkopf lediglich die Seitenränder des seitlich an dem Bauteil aufgebrachten Verguß- bzw. Plattenmaterials abtasten und erhält somit keine exakte Information über die tatsächliche seitliche Lage des eingegossenen oder mit Platte versehenen Bauteils. Dies kann die Gefahr unerwünschter Fehlpositionierungen begründen. Insbesondere bei Spulen, aber auch bei anderen Bauteilen wie etwa Kapazitäten und dergleichen, kann eine solche Fehlpositionierung schon bei sehr geringem Ausmaß von beispielsweise 0,1 mm dazu führen, daß die elektrische Funktion der das montierte Bauteil enthaltenden elektrischen Gesamtschaltung aufgrund von induktiven oder kapazitiven Abweichungen oder Fehlkontaktierungen beeinträchtigt sein.

Aus der DE-A-36 15 307 ist ein als Luftspule ausgebildetes elektrisches Bauteil bekannt, bei dem zur SMD-Bestückung mittels einer Ansaugpipette eine plane Schicht an der Oberseite der Spule ausgebildet ist, die genau der viereckigen Form der Spule entspricht und seitlich nicht über das Bauteil hinausragt.

Einerseits ist aber die Wickeltechnik zum Herstellen derartiger viereckiger Spulen recht aufwendig. Andererseits muß für das Ausbilden der planen Schicht oder einer Einkapselung eine Gußform mit hoher Präzision hergestellt werden.

Hierbei bereitet es auch Schwierigkeiten, das Bauelement exakt in der Gießform so zu positionieren, daß die gewünschte Schichtdicke allseitig erhalten wird und das Bauelement darüber hinaus noch mit seinen Seitenrändem in exakter, vorbestimmter Beziehung zu den Seitenrändem der Gießform und damit der resultierenden Vergußmasse steht. Aufgrund von stets unvermeidlichen Toleranzen kann die Schichtdicke der seitlich an die Seitenränder des Bauteils angrenzenden Schicht variieren, so daß der äußere Seitenrand der Bauteilhülle nicht in stets exakt definierter Beziehung mit der seitlichen Randlage des elektrischen Bauteils, d.h. der eigentlichen Funktionskomponente, beispielsweise der Spule, steht. Eine exakte Positionierung der seitlichen Lage des Gußgehäuses stellt somit nicht sicher, daß auch das darin befindliche elektrische Bauteil mit seinen seitlichen Rändern exakt richtig positioniert ist. Darüber hinaus begründet der Eingießschritt auch generell einen relativ hohen Aufwand.

Der Erfindung liegt die Aufgabe zugrunde, ein elektrisches Bauteil zu schaffen, das kostengünstig herzustellen ist und auch bei SMD-Montagetechnik eine exakte Positionierung ermöglicht.

Dies Aufgabe wird mit den im Anspruch 1 angegebenen Merkmalen gelöst.

Vorteilhafte Ausgestaltungen der Erfindung sind in den Unteransprüchen angegeben.

Bei dem erfindungsgemäßen elektrischen Bauteil ist somit auf einer Bauteilseite, insbesondere der Oberseite, ein Massepunkt mit einer Oberseite angebracht, der nicht über die Seitenkanten des Bauteils hinausragt, sondern von zumindest einer Seitenkante beabstandet ist. Mit dieser Gestaltung werden mehrere Vorteile gleichzeitig erreicht. Einerseits ermöglicht die plane Oberfläche des Massepunkts ein zuverlässiges Ergreifen, Hantieren und Ausrichten des Bauteils mittels üblicher Bestückungsautomaten. Selbst Bauteile mit unebener Oberfläche wie etwa Wickelspulen mit kreisförmigem Querschnitt lassen sich somit mit planer Oberfläche versehen, die eine zuverlässige Hantierung erlaubt.

Anderseits ragt der Massepunkt bei dem erfindungsgemäßen Bauteil nicht über dessen Seitenränder hinaus, d.h. ist tatsächlich nur auf einer einzigen Bauteilseite aufgebaut. Die Seitenränder des Bauteils bleiben somit frei zugänglich, so daß sie mechanisch oder optoelektrisch zuverlässig abgetastet werden können und ihre jeweilige Lage exakt feststellbar ist. Dies erlaubt eine hohe Präzision bei der Handhabung und/oder Bestückung bzw. Positionierung der elektrischen Bauteile.

Da der Massepunkt die Seitenränder des vorzugsweise elektrischen Bauteils freiläßt, ist er auch in unproblematischer Weise aufbringbar und erfordert keine spezielle Gußform. Beispielsweise ist es möglich, weiches, zum Beispiel erwärmtes Material punktförmig auf die Bauteiloberfläche aufzubringen und dann im noch weichen Zustand mittels einer planen Fläche zu drücken, so daß die Oberfläche des Massepunkts plan wird. Bei Abkühlung erstarrt das Material, so daß das Bauteil zuverlässig über den Massepunkt ergriffen werden kann.

Da für den Massepunkt folglich nur relativ geringe Materialmenge aufzubringen ist, ergibt sich auch keine nennenswerte Erhöhung des Gesamtgewichts des Bauteils, was der präzisen Handhabung gleichfalls zugute kommt.

Die erfindungsgemäße Gestaltung ermöglicht auch eine zuverlässige Handhabung von elektrischen Spulen, deren Windungen gegenseitigen Abstand besitzen. Der Massepunkt stellt eine plane Ansaugfläche auch bei solchen Spulen bereit.

In bevorzugter Ausgestaltung ist der Massepunkt so Klein, daß er nicht bis zu den Seitenrändem des Bauteils reicht, so daß diese auch von der Seite des Massepunkts aus betrachtet allerdings freiliegen, auch von der Oberseite ohne Störung durch den Massepunkt ergriffen oder abgetastet werden können.

In bevorzugter Ausgestaltung ist der Massepunkt im wesentlichen symmetrisch auf dem Bauteil angeordnet, so daß z. B. eine symmetrische Ansaugung durch die Ansaugpipette eines Bestückungsautomaten möglich ist. Damit ist jegliche Verkippungsgefahr ausgeschaltet. Der Massepunkt ist vorzugsweise in Draufsicht im wesentlichen kreisförmig. Damit läßt sich mit sehr geringem Materialbedarf für den Massepunkt eine großflächige plane Oberfläche ausbilden. Die im wesentlichen kreisförmige Form läßt sich durch Aufbringen eines Massepunkts und Niederdrücken desselben mittels planer Bearbeitungswerkzeugfläche auch in einfacher und definierter Weise herstellen. Wenn es allerdings erforderlich wird, kann der Massepunkt auch länglich sein, was beispielsweise bei einer Antennenplazierung im Handmobilfunkgerät der Fall wäre.

Der Massepunkt ist vorzugsweise an der den elektrischen Kontaktanschlüssen gegenüberliegenden Bauteilseite angebracht, so daß sich eine einfache Positionierbarkeit des Bauteils auf einem Schaltungssubstrat ergibt.

In bevorzugter Ausgestaltung ist das Bauteil eine Spule, die durch eine Spiralwicklung gebildet ist. Die Spiralwicklung ist vorzugsweise selbsttragend und stellt damit ein Bauteil mit im wesentlichen zylindrischem Außenumfang dar, das vorzugsweise keinen Magnetkern und kein Magnetjoch besitzt, d.h. als Luftspule ausgebildet ist. Die Spule kann jedoch auch mit Magnetkern versehen sein. Trotz in Axialrichtung gesehener kreisförmiger Krümmung der Spulenoberfläche ergibt sich über den Vergußmassepunkt folglich eine plane Oberfläche, die erleichterte Handhabung ermöglicht. Insbesondere bei der Verwendung von bewickelten Ringkerne besteht die Möglichkeit, in den Innenraum des Ringkerns als Massepunkt einen Stopfen vorzugsweise aus Gummi einzuführen, dessen eine Oberfläche als Ansaugfläche gedacht ist.

Gemäß einer besonderen Ausgestaltung besteht der Massepunkt aus Vergußmasse. Die Vergußmasse läßt sich in einfacher Weise in erwärmtem Zustand zum Beispiel tropfenförmig auf das Bauteil auftragen und dann mittels planflächigen Bearbeitungswerkzeugs niederdrücken, so daß sich die Vergußmasse etwas großflächiger auf dem Bauteil verteilt und gleichzeitig eine plane Oberfläche ausbildet. Nach Erstarrung ist die Vergußmasse hoch belastbar.

Vorzugsweise ist der Massepunkt bei Bauteilen mit nicht planer Oberfläche so stark gedrückt, daß die Ebene der Ansaugfläche den höchsten Punkt des Bauteils gerade berührt, d.h. das Bauteil mit seinem höchsten Punkt gerade noch in die Ebene der Ansaugfläche ragt. Dies läßt sich dadurch erreichen, daß das zum Beispiel auf die Vergußmasse drückende Bearbeitungswerkzeug mit planer Oberfläche so stark auf das Bauteil gedrückt wird, daß es dessen Oberfläche kontaktiert. Die Vergußmasse fließt dann soweit zur Seite, daß sich ein Massepunkt ergibt, dessen plane Oberfläche die Bauteiloberseite gewissermaßen tangential berührt. Dies hat den Vorteil, daß die Bauteildicke nicht erhöht wird, so daß der gesamte Raumbedarf des mit Massepunkt versehenen Bauteils weder in Längen- noch in Breiten- oder Dickenrichtung vergrößert wird.

Der Massepunkt kann auch aus ausgehärtetem Klebstoff, beispielsweise Ein- oder Zweikomponenten-Kleber bestehen. Es ist auch möglich, den Massepunkt aus Kunststoff herzustellen, wobei dieser zum Aufbringen des Massepunkts vorzugsweise so stark erwärmt wird, daß er zumindest fließfähig ist, und bei der nachfolgenden Abkühlung wieder erstarrt. Dies ermöglicht eine definierte Formgebung des Massepunkts.

Die Erfindung wird nachstehend anhand von Ausführungsbeispielen unter Bezugnahme auf die Zeichnungen näher beschrieben. Es zeigt:

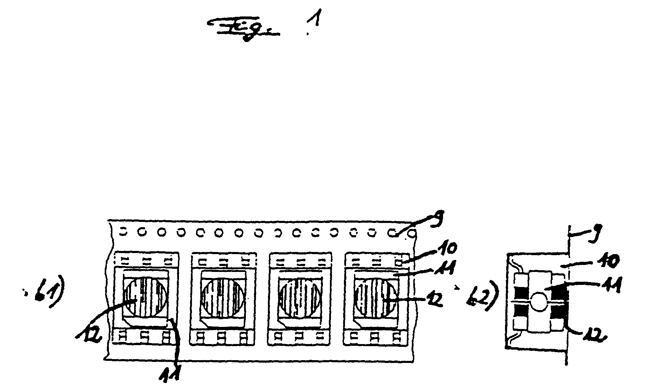

Fig. 1, die sich aus Zeichnungsteilen b1) und b2) zusammensetzt, Draufsichten und Seitenansichten eines Ausführungsbeispiels von erfindungsgemäßen elektrischen Bauteilen.

In Fig. 1 ist ein Ausführungsbeispiel des erfindungsgemäßen elektrischen Bauteils in Form eines kleinen Transformators mit umgebendem Joch gezeigt, der für SMD-Oberflächenmontage ausgelegt ist. Der Transformatordurchmesser ist so groß, daß der Transformator stabil und selbsttragend ist. Wie aus den Figuren ersichtlich ist, liegen die entgegengesetzten Anschlußenden 2, 3 des Buateils 11 in einer tangential zum Transformator verlaufenden Ebene und sind im Unterschied zum übrigen Bereich des Bauteils nicht mit einer Isolation versehen. Der Transformator 11 wird bei seiner Montage mit ihren Anschlußenden 2, 3 auf die dazugehörige, nicht dargestellte Leiterplatine aufgesetzt und dort verklebt und/oder verlötet.

Auf der den Anschlußenden 2, 3 gegenüberliegenden Bauteilseite, ist ein Massepunkt 12 aufgebracht, der plane Oberfläche beisitzt. Die plane Oberfläche des Massepunkts 12 verläuft parallel zur Ebene der Anschlußenden 2, 3, so daß Transformator 11 bei Handhabung mittels Bestückungsautomaten oder dergleichen über die plane Oberfläche des Massepunkts 12 so gehalten werden kann, daß auch die Ebene der Anschlußenden 2, 3 definierte Position besitzt und somit der Transformator 11 z.B. verkippungsfrei auf die zugeordnete Leiterplatine aufgesetzt werden kann.

Wie aus den Figuren ersichtlich ist, sind die Abmessungen des Massepunkts 12 deutlich kleiner als die axiale Länge und Breite des Transformators 11. Damit ragt der Massepunkt 12 nicht nur nicht über die Seitenkanten des elektrischen Bauteils 1 hinaus, sondern endet an zwei Seitenkanten mit Abstand zu diesen. Damit sind zumindest zwei Seitenkanten des elektrischen Bauteils nicht durch den Massepunkt 12 überdeckt und können folglich exakt und zuverlässig mechanisch oder optoelektrisch abgetastet werden. Auch ist die benötigte Massepunkt-Materialmenge entsprechend gering. Insbesondere aus Fig. 1a1) ist weiterhin erkennbar, daß der Massepunkt im wesentlichen kreisförmige Gestaltung besitzt, so daß auch die plane Oberfläche im wesentlichen kreisförmig ist. Weiterhin ist ersichtlich, daß der Massepunkt 12 im wesentlichen symmetrisch und mittig auf der Bauteil-Oberseite aufgebracht ist.

Aus den Figuren ist weiterhin erkennbar, daß der Massepunkt 12 derart auf dem Bauteil aufgebracht ist, daß seine plane Oberfläche im wesentlichen tangential zum Außenumfang des Transformators verläuft. Dies bedeutet, daß die Dicke des elektrischen Bauteils einschließlich Massepunkt 12 nicht oder allenfalls nur unwesentlich größer ist als die Dicke ohne Massepunkt 12. Die Gesamtdicke bzw. -höhe des Bauteils 11 ist folglich allenfalls unwesentlich vergrößert, so daß das Bauteil 11 weiterhin äußerst kompakt bleibt.

Das Merkmal, daß die plane Oberfläche im wesentlichen tangential zum Außenumfang des Transformators verläuft, hat weiterhin zur Folge, daß die Menge des für den Massepunkt benötigten Materials äußerst gering ist, da in der Mitte im wesentlich kein Material aufgebaut wird. Dennoch ergibt sich eine großflächige plane Oberfläche des Massepunkts und damit des entsprechenden Bereichs des erfindungsgemäßen Bauteils, so daß die Handhabung sehr einfach und stabil erfolgen kann.

Aus den Zeichnungen ist ersichtlich, daß der erfindungsgemäße Massepunkt vor allem bei elektrischen Bauteilen mit nicht planer Oberfläche vorteilhaft ist. Allerdings läßt sich der Massepunkt auch auf elektrischen Bauteilen aufbringen, die von Haus aus plane Oberfläche besitzen, insbesondere, wenn die Bauteiloberfläche für sich nicht ausreichend belastbar oder zu spröde sein sollte. Hier kann der Massepunkt auch eine entsprechende Versteifung bewirken und sicherstellen, daß das elektrische Bauteil über die plane Oberfläche des Massepunkts unproblematisch angesaugt werden kann.

In Fig. 1 b1), b2) sind ferner mehrere gleichartige elektrische Bauteile 11 in regelmäßig angeordneten Vertiefungen 10 eines Blisterstreifens 9 derart eingelegt, daß sie sich mit ihren Anschlußfahnen auf der Bodenseite der Vertiefungen 10 abstützen. Auf jedem Bauteil 11 ist jeweils ein im wesentlichen kreisförmiger Massepunkt 12 mittig auf der den Anschlußfahnen gegenüberliegenden Oberseite aufgebracht. Der Massepunkt 12 besitzt plane Oberfläche und verleiht der gestuften Oberfläche des Bauteils 11 somit eine plane Oberfläche, die eine zuverlässige Ansaugung ermöglicht.

Das Material des Massepunkts 12 besteht vorzugsweise aus Vergußmasse, die im weichen Zustand auf die Bauteiloberdläche aufgebracht und dann von oben mit planer Bearbeitungsfläche zusammengedrückt wird, so daß sich eine plane Massepunkt-Oberfläche ausbildet.

Als Material des Massepunkts kann jedes geeignete Material verwendet werden, das eine gewünschte Formgebung erlaubt und im Einsatzzustand ausreichende Festigkeit besitzt.

## Patentansprüche

1. Bauteil, insbesondere Spule vorzugsweise für SMD-Montagetechnik, dadurch gekennzeichnet, daß auf einer Bauteil-Seite, insbesondere der Bauteil-Oberseite, ein Massepunkt (14) aufgebracht ist, der eine Oberfläche besitzt und derart angeordnet ist, daß er gegenüber zumindest einem Seitenrand des Bauteils beabstandet ist.

2. Bauteil nach Anspruch 1, dadurch gekennzeichnet, däß der Massepunkt gegenüber zwei Seitenränder des Bauteils beabstandet ist.

3. Bauteil nach Anspruch 2, dadurch gekennzeichnet, daß die zwei Seitenränder des Bauteils sich gegenüber liegen.

4. Bauteil nach einem der Ansprüche 1 bis 3, dadurch gekennzeichnet, daß der Massepunkt (14) im wesentlichen symmetrisch auf dem Bauteil (11) angeordnet ist.

5. Bauteil nach einem der vorhergehenden Ansprüche, dadurch gekennzeichnet, daß der Massepunkt (14) in Draufsicht im wesentlichen kreisförmig ist.

6. Bauteil nach einem der Ansprüche 1 bis 5, dadurch gekennzeichnet, daß das Bauteil elektrisch ist.

7. Bauteil nach Anspruch 6, dadurch gekennzeichnet, daß der Massepunkt (14) auf der den elektrischen Kontaktanschlüssen (2, 3) des Bauteils (11) gegenüberliegenden Bauteilseite angebracht ist.

8. Bauteil nach einem der vorhergehenden Ansprüche, dadurch gekennzeichnet, daß das Bauteil eine durch eine Spiralwicklung gebildete Spule (11), vorzugsweise ein Mehrkammerspulenkörper oder bewickelte Ringkerne ist.

9. Bauteil nach einem der vorhergehenden Ansprüche, dadurch gekennzeichnet, daß der Massepunkt aus Vergußmasse besteht.

10. Bauteil nach einem der Ansprüche 1 bis 8, dadurch gekennzeichnet, daß der Massepunkt aus ausgehärtetem Klebstoff besteht.

11. Bauteil nach einem der Ansprüche 1 bis 8, dadurch gekennzeichnet, daß der Massepunkt (14) aus Kunststoff besteht.

12. Bauteil nach einem der Ansprüche 1 bis 11, dadurch gekennzeichnet, däß der Massepunkt eine plane Oberfläche aufweist.
